Europäisches Patentamt

European Patent Office

Office européen des brevets

(11) Publication number: **0 077 559**
**B1**

# EUROPEAN PATENT SPECIFICATION

(45) Date of publication of patent specification: **20.05.87**

(21) Application number: **82109606.2**

(22) Date of filing: **18.10.82**

(51) Int. Cl.⁴: **H 01 L 21/68**

(54) **Wafer surface contouring device.**

(30) Priority: **19.10.81 JP 165772/81**

(43) Date of publication of application:
**27.04.83 Bulletin 83/17**

(45) Publication of the grant of the patent:
**20.05.87 Bulletin 87/21**

(84) Designated Contracting States:
**DE FR**

(56) References cited:
**FR-A-2 369 610**
**US-A-3 729 966**
**US-A-3 903 435**

**IBM TECHNICAL DISCLOSURE BULLETIN, vol. 16, no. 11, April 1974, pages 3810,3811, New York, USA. G. A. WARDLY: "Electrostatic wafer flattener"**

(73) Proprietor: **Hitachi, Ltd.**
**5-1, Marunouchi 1-chome**
**Chiyoda-ku Tokyo 100 (JP)**

(72) Inventor: **Kenbo, Yukio**
**1545 Yoshida-cho Totsuka-ku**
**Yokohama-shi Kanagawa-ken (JP)**
Inventor: **Akiyama, Nobuyuki**
**27-1, Torigaoka Totsuka-ku**
**Yokohama-shi Kanagawa-ken (JP)**
Inventor: **Koizumi, Mitsuyoshi**
**728-1, Sinbashi-cho Totsuka-ku**
**Yokohama-shi Kanagawa-ken (JP)**
Inventor: **Kuni, Asahiro**
**4-20-6, Nakamachi**
**Setagaya-ku Tokyo (JP)**

(74) Representative: **Patentanwälte Beetz sen. -**
**Beetz jun. Timpe - Siegfried - Schmitt-Fumian**
**Steinsdorfstrasse 10**
**D-8000 München 22 (DE)**

Courier Press, Leamington Spa, England.

## Description

### Background of the Invention

The present invention relates to a wafer surface contouring device which contours the surface of a base material in accordance with the shape of a mask when a pattern formed on the mask is to be transferred onto a resist film formed on the surface of the base material.

An IC (integrated circuit) or LSI (large-scale integrated circuit), for example, is manufactured into a required circuit arrangement by forming a resist film on a wafer made of silicon, transferring onto the resist film a required pattern formed on a mask, and repeatedly performing the processing of etching, ion implantation in accordance with the transferred pattern.

In the LSI, for enhancing the density of integration more, it is required to form a fine pattern in which the width of a line to constitute the circuit is 1 μm or less. To the end of meeting such requirement, it has been proposed to employ soft X-rays for the transfer of the pattern.

Several X-ray exposure apparatuses employing the soft X-rays have been proposed. It is known, however, that the soft X-rays decay much in the course in which they proceed from a generation source thereof up to the resist film formed on the wafer.

Therefore, various improvements have been made which include the measure of increasing the generation dose of the soft X-rays in the X-ray source, the measure of forming the mask by the use of a material easy of transmitting the soft X-rays and also thinning the mask to the utmost, and so on.

When the mask is thinned, the mechanical strength of the mask lowers to that extent, and hence, a large mask cannot be fabricated. Therefore, a step-and-repeat type transfer method has been proposed in which a mask corresponding to one LSI is prepared, and in which wafers are moved one by one after the corresponding pattern has been transferred. However, when the mask is thin, it is difficult to flatten the mask itself.

On the other hand, the soft X-rays propagate rectilinearly while spreading radiately from the generation source. In addition, the generation source of the soft X-rays has a size which corresponds to the diameter of an electron beam to irradiate an anticathode. In consequence, a deviation corresponding to the size of the generation source is involved in the arrival position of the soft X-rays which propagate from the generation source through the mask to the resist film on the wafer. This gives rise to defocusing, or the shift in which a position somewhat deviating from a position directly under the mask pattern is irradiated.

Moreover, the mask undergoes various unfavorable influences. They include, for example, errors in the fabrication of the mask, a distortion ascribable to temperature rise at the exposure, a deformation ascribable to chucking in the case of setting the mask on the exposure apparatus, a distortion ascribable to the weight of the mask itself, and a distortion ascribable to the difference between pressures acting on the upper and lower surfaces of the mask. When the mask is repeatedly used, it also undergoes a distortion ascribable to a change-with-time thereof. On the other hand, the wafer undergoes various unfavorable influences which include a deformation in the fabrication of the mask, a deformation ascribable to chucking in the case of setting the wafer on the exposure apparatus, deformations incurred in such processes as etching and ion implantation, and so on.

Accordingly, in order to transfer the circuit pattern of or narrow than 1 μm, the surface part of the wafer to be exposed to the soft X-rays needs to be transformed so that the pattern projected from the mask can be received in the best condition.

As a device for metting such requirement, by way of example, a "FLATNESS CONTROLLED WAFER CLAMPING PEDESTAL" has been proposed in IBM Technical Disclosure Bulletin (Vol. 15, No. 10, March 1973).

More specifically, piezoelectric elements are arranged on the clamping pedestal which is formed with an opening for vacuum suction. In the state in which a wafer is placed on the pedestal and held in the vacuum suction, the heights of a plurality of points on the front surface of the wafer are detected by sensors. On the basis of the detected results, required voltages are applied to the piezoelectric elements, so as to push up the rear surface of the wafer. Thus, the front surface of the wafer is made horizontal.

In such apparatus, however, when the wafer is pushed up by the piezoelectric elements, a gap appears between the pedestal and the wafer. This leads to such disadvantages that the force of holding the wafer by vacuum weakens and that the wafer is liable to slip due to air current flowing through the gap. Further, unless the piezoelectric elements are arranged uniformly over the whole area of the wafer, this wafer cannot be contoured to be horizontal or into a required shape. Therefore, by way of example, 105 piezoelectric elements are required in a case where the piezoelectric elements are arranged at intervals of 10 mm on the entire surface of a 4-inch wafer, and 140 piezoelectric elements are required in a case of a 5-inch wafer. Likewise, drive means for the piezoelectric elements are required in the same number as that of these elements. Since the drive means usually needs to apply voltages of 0—650 V to the piezoelectric elements, it is technically difficult to be rendered small in size. Accordingly, it is technically difficult to furnish the exposure apparatus with the large number of drive means, resulting in such disadvantages that the apparatus becomes unnecessarily large in size and that it becomes expensive.

### Summary of the Invention

The object of the present invention is to provide a wafer surface contouring device in which the force of holding a wafer is not lowered, and the number of drive means for piezoelectric elements is equalized to that of the piezoelectric elements to be actuated at one exposure, thereby permitting an exposure apparatus to be made small in size and an exposure precision to be enhanced.

In order to accomplish the object, according to the present invention a wafer surface contouring device for use in an exposure apparatus for exposing a circuit pattern of a mask on a wafer in a step-and-repeat type transfer method is provided, wherein in said wafer surface contouring device a front surface of a wafer is transformed into a predetermined shape by distorting forces applied upon the rear surface of the wafer which is retained by vacuum suction on said rear surface, the wafer surface contouring device comprising: a hollow case closed on one lower open side by a base on which said hollow case is resting, said hollow case on an upper open side being covered with a diaphragm type chuck, said hollow case, said base, and said diaphragm type chuck forming an airtight space, said diaphragm type chuck having outside of said airtight space an upper surface formed with a suction groove for retaining said wafer by vacuum suction; and a plurality of vertically moving elements arranged at predetermined intervals in predetermined positions within said airtight space for applying said distorting forces upon said rear surface of said wafer through said diaphragm type chuck; characterized in that said wafer surface contouring device further comprises drive means for selectively actuating only the vertical moving elements according to the area to be exposed on the wafer.

Brief Description of the Drawings

Figure 1 is a perspective view showing an example of an X-ray exposure apparatus to which a wafer surface contouring device of the present invention is applied;

Figure 2 is a front view, partly in section, showing an embodiment of the wafer surface contouring device according to the present invention;

Figure 3 is a block diagram showing an example of driving circuits for the wafer surface contouring device shown in Figure 2;

Figure 4 is a plan view showing the positional relationship between a wafer and vertically moving elements;

Figure 5 is a plan view showing the correspondence between the vertically moving elements and the driving circuits thereof; and

Figure 6 is a model diagram showing the correspondence between the vertically moving elements and the driving circuits thereof.

Description of the Preferred Embodiment

Hereunder, an embodiment of the present invention will be described with reference to the drawings.

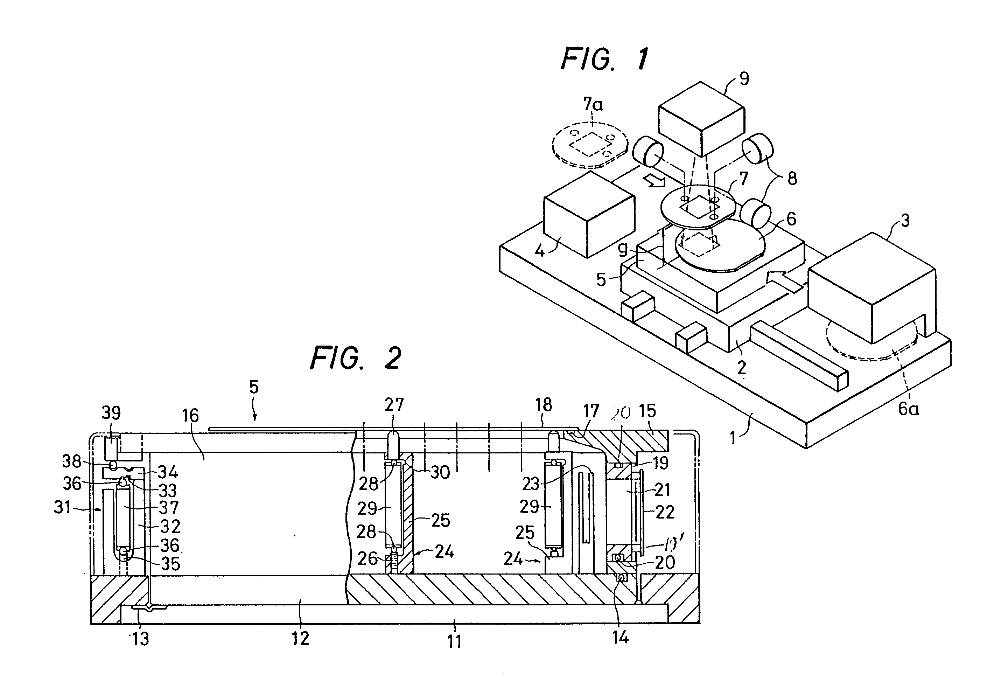

Figure 1 shows an example of a soft X-ray exposure apparatus to which a wafer surface contouring device according to the present invention is applied.

Referring to the figure, an X—Y table 2 is arranged centrally on a base 1, and a wafer flatness detector 3 and a mask flatness detector 4 are arranged on both the sides thereof. A wafer transforming device 5 is arranged on the X—Y table 2, and a wafer 6 whose flatness has been detected is placed and fixed on the former. A mask 7 whose flatness has been detected is arranged over the wafer 6 in a manner to oppose to the latter with a minute gap $g$ therebetween. Alignment detectors 8 are arranged over the mask 7. In interlocking with the outputs of the alignment detectors 8, the X—Y table 2 moves to execute the positioning between the mask 7 and the wafer 6. When the positioning between the mask 7 and the wafer 6 has ended, the wafer surface contouring device 5 operates to contour the surface of the wafer 6 into a required shape. Further, a soft X-ray generator 9 is disposed over the mask 7 in such a manner that soft X-rays produced by the generator 9 are projected on the wafer 6 through the mask 7. At this time, when a resist film reacting with the soft X-rays is formed on the wafer 6, a pattern formed on the mask 7 can be transferred onto the resist film.

Figure 2 shows an example of the wafer surface contouring device 5 according to the present invention. Referring to the figure, an annular stationary base 11 is placed and fixed on the X—Y table. A base 12, which is arranged in a manner to lie centrally of the base 11, is coupled to the stationary base 11 by three leaf springs 13 which are arranged at intervals of 120 degrees. An annular groove is formed in the upper part of the base 12, and an O-ring 14 is installed therein. A hollow case 16, which is formed with an annular flange 15 at its upper end, is placed and fixed on the O-ring 14 so as to hold the airtightness between the base 12 and the case 16. An annular groove 17 for vacuum suction is formed on the inner peripheral edge side of the upper end face of the flange 15. A diaphragm type chuck 18, which is placed on the flange 15 in a manner to cover the groove 17, is fixed by suction owing to vacuum which is established in the groove 17. A shallow groove is formed in the upper surface of the chuck 18 by etching or the like, and the wafer is chucked by vacuum suction through this groove. A penetrating hole 19 is formed in the side surface of the case 16. An annular frame 19' fitting in the penetrating hole 19 is formed with a groove in its outer periphery, and an O-ring 20 is inserted in this groove so as to hold the airtightness between the case 16 and the frame 19' when the latter 19' is mounted on the former 16. Regarding the frame 19', a plurality of pipes (not shown) and a plurality of wiring leads (not shown) penetrate through the central part of this frame structure. The pipes serve to supply a vacuum pressure to a space defined by the base 12, case 16 and chuck 18, and also to the groove 17 and the groove of the surface of the chuck 18 through the aforementioned space, while the wiring leads serve to apply voltages to piezoelectric elements to be described later. The remaining space of the frame 19' is filled up with a filler 21, which holds an airtight state. A bracket 22 for supporting the pipes and the wiring leads is fixed to the outer side surface of the frame 19'. On the other hand, a bracket 23 for supporting the pipes and the wiring leads is erected on the base 12 in a manner to lie inside the frame 19'. A large number of vertically moving elements 24 are arranged on the base 12 in a predetermined arrayal. (The vertically moving elements 24 numbers 105 when they are arranged on the whole surface of a 4-inch wafer at intervals of 10 mm. Hereinbelow, the case of the 105 elements will be referred to.) Each of the vertically moving elements 24 is constructed of a channeled case 25 which is fixed to the base 12, an adjusting screw 26 which is held in threadable engagement with a screw hole formed in the lower end of the case 25, a chip 27 for taking out a displacement value, which is held in threadable engagement with a screw hole formed in the upper end of the case 25, and the piezoelectric element 29 which is supported between a pair of steel balls 28 lying in contact with the screw 26 and the chip 27 respectively. A notch 30 is formed in the upper part of the case 25 so as to facilitate the elastic deformation of the upper end of the case 25. In addition, the piezoelectric element 29 is connected to the wiring leads. On the stationary base 11, three vertically moving elements 31 are arranged at intervals of 120 degrees in correspondence with the leaf springs 13. Each of the vertically moving elements 31 is constructed of a U-shaped case 32 which is fixed to the stationary base 11, a chip 34 for taking out a displacement value, which has its one end fixed to the upper end of the case 32 and which is formed to be elastically deformable owing to a notch 33, an adjusting screw 35 which is held in threadable engagement with a screw hole formed in the lower end of the case 32, and a piezoelectric element 37 which is supported between the chip 34 and the screw 35 through a pair of steel balls 36. The chip 34 carries a bracket 39 arranged on the flange 15 of the case 16, by means of a steel ball 38 placed on the upper surface thereof, whereby the case 16 is supported. Accordingly, when the vertically moving elements 31 operate, the inclination of the whole chuck 18 can be changed. Moreover, when the vacuum pressure is supplied to the space defined by the base 12, case 16 and chuck 18, this chuck 18 is depressed by the atmospheric pressure until it comes into contact with the chips 27 of the vertically moving elements 24. Thus, the chuck 18 is supported by the vertically moving elements 24. Accordingly, when the wafer is supported on the chuck 18 by suction, its surface is also contoured like the surface of the chuck 18.

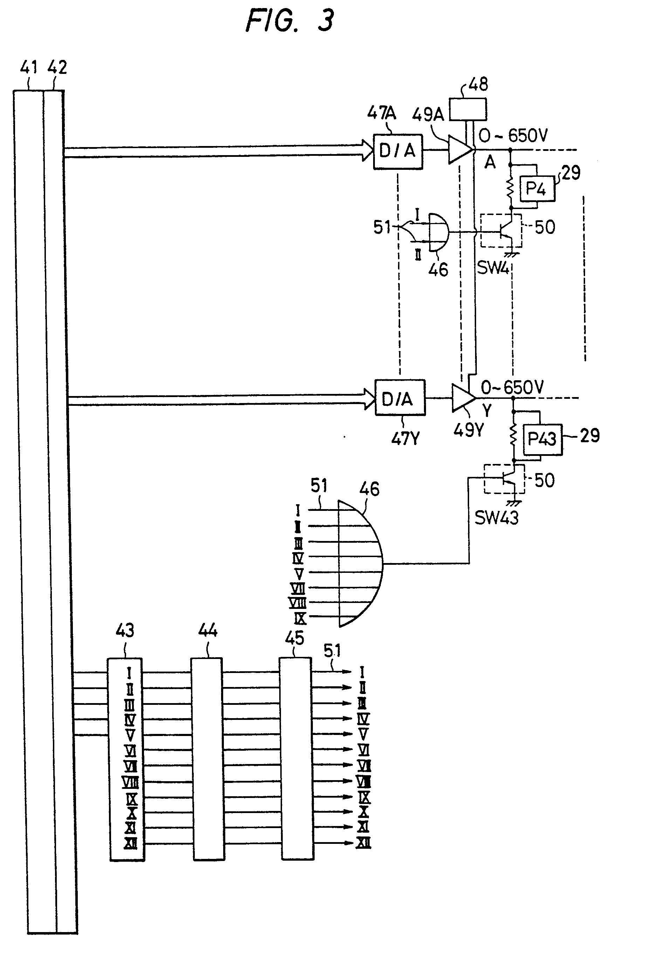

Figure 3 shows an example of a drive circuit for the vertically moving elements 24 in Figure 2. A CPU 41 in Figure 3 is connected to the wafer flatness detector 3 and the mask flatness detector 4 shown in Figure 1, and stores the detection data of the respective detectors 3 and 4. Besides, it finds the deformation values of the wafer 6 by the vertically moving elements 24, that is, the voltages to be applied to the piezoelectric elements 29 of the vertically moving elements 24. On the basis of a command of the CPU 41, an output port 42 connected to the CPU 41 provides selection signals for the vertically moving elements 24 to be operated and the digital values of the voltages to be applied to the respective vertically moving elements 24. On the basis of the selection signals applied from the output port 42, a decoder 43 connected to the output port 42 generates signals for assigning sections (12 divisions in the embodiment) which are previously set in correspondence with the step-and-repeat movements of the X—Y table 2. A latch circuit 44, which is connected to the decoder 43, latches the signals delivered from the decoder 43. In response to signals applied from the latch circuit 44, a buffer circuit 45 connected to the latch circuit 44 applies actuating signals to the switching circuits (to be described below) of the piezoelectric elements 29 to be actuated, through OR circuits 46. On the other hand, twenty-five digital-to-analog converters 47A—47Y connected to the output port 42 are supplied with the digital signals based on the calculated results of the CPU 41. Twenty-five amplifiers 49A—49Y connected to a high voltage source 48 and the D/A converters 47A—47Y derive required voltages from a voltage supplied from the high voltage source 48, on the basis of analog signals delivered from the D/A converters 47A—47Y. The piezoelectric element 29, and the switching circuit 50 formed of a transistor connected to this piezoelectric element are connected in parallel with each of the amplifiers 49A—49Y. The switching circuits 50 are supplied with the actuating signals 51 generated from the buffer circuit 45. When the switching circuits 50 supplied with the actuating signals 51 have operated, the piezoelectric elements 29 connected to these switching circuits are supplied with the voltages from the amplifiers 49A—49Y.

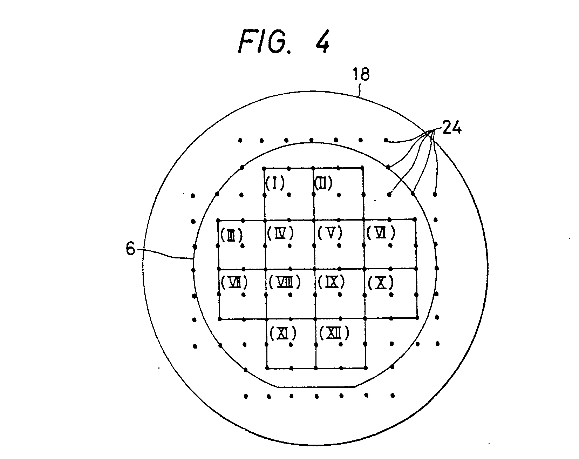

The above construction will be explained more as to a case where the wafer 6 carried on the chuck 18 is divided into the twelve sections (I)—(XII) as shown by way of example in Figure 4 and then exposed to the soft X-rays. The vertically moving elements 24 are arranged underneath the chuck 18. At one exposure, as to each of the exposure ranges (I)—(XII), the twenty-five vertically moving elements 24 in and around the particular exposure range are actuated so as to prevent the contoured state of this exposure range from being affected by uncontoured parts in the surrounding.

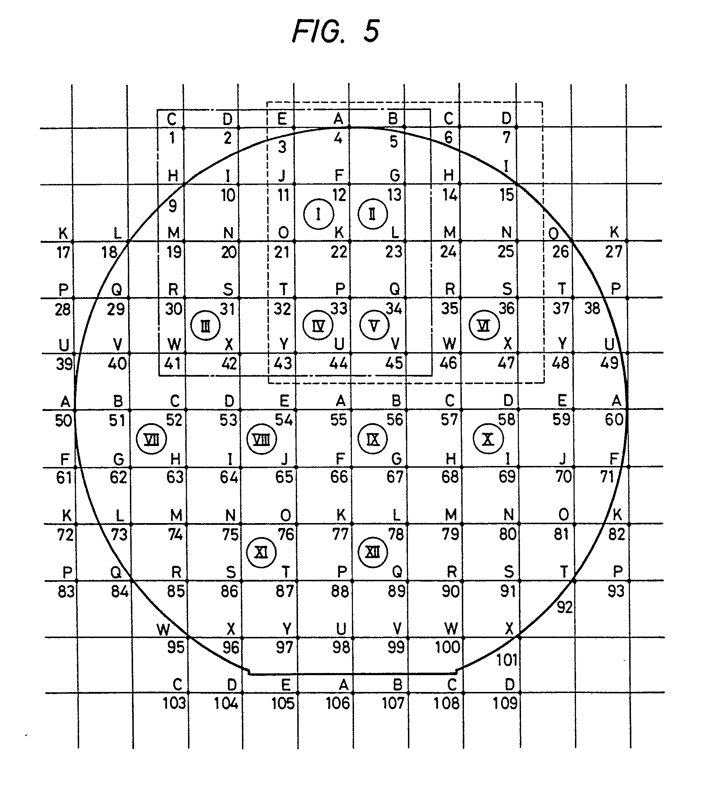

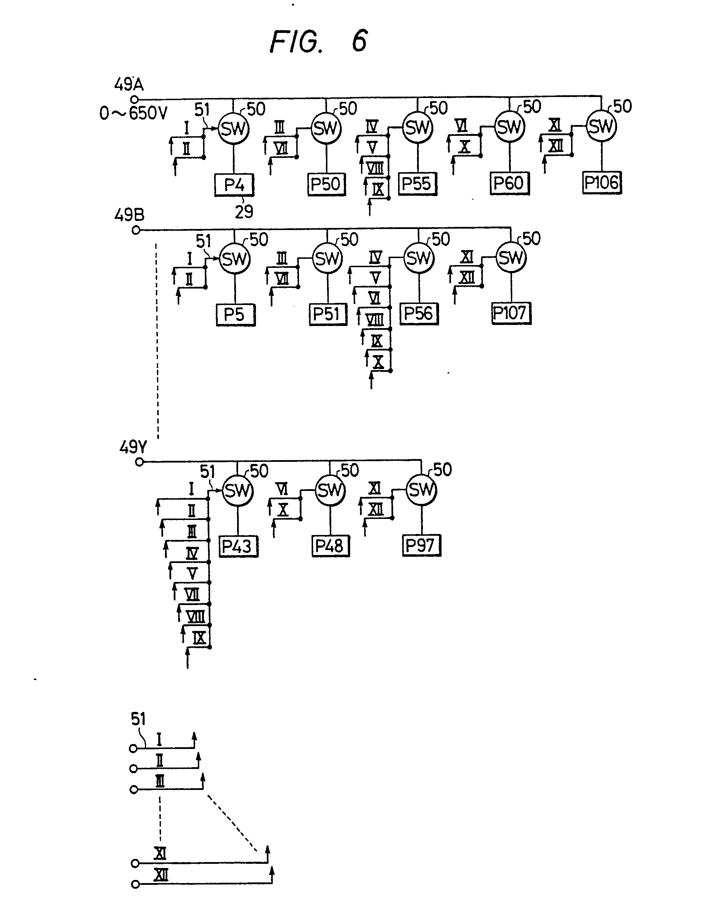

The one-hundred-and-five vertically moving elements 24, and the twenty-five amplifiers 49A—49Y for driving them correspond as shown in Figure 5. More specifically, when the 105 vertically moving elements 24 are indicated by numerals 1—109 (in which numerals 8, 16, 94 and 102 are wanting) and the 25 amplifiers 49A—49Y are indicated by letters A—Y, the vertically moving element 1 is driven by the amplifier C in case of the section (I). Likewise, the vertically moving element 2 is driven by the amplifier D, and the corresponds relations of 3 — E, 4 — A, 5 — B, 9 — H, 10 — I, . . ., 44 — U, and 45 — V hold. In case of the section (II), the corresponding relations of 3 — E, 4 — A, 5 — B, 6 — C, 7 — D, 11 — J, 12 — F, . . ., 46 — W, and 47 — X hold. Figure 6 typically shows such relations. As seen from this figure, the generation of the actuating signal 51 of the amplifier I from the buffer 45 results in actuating the fourth piezoelectric element 29 (P4) of the vertically moving element 24 connected to the amplifier 49A, the fifth piezoelectric element 29 (P5) of the vertically moving element 24 connected to the amplifier 49B, . . ., and the forty-third piezoelectric element 29 (P43) of the vertically moving element 24 connected to the amplifier 49Y.

In this way, when the CPU 41 has generated the section assignment signal and the digital signals of the voltages to be provided from the respective amplifiers 49A—49Y in the particular section, the twenty-five vertically moving elements 24 in the exposure region and the surrounding thereof are actuated, whereby the exposure region of the wafer 6 can be contoured into a required shape.

The vertically moving elements 31 function when the entire wafer 6 is slant, to render the entire wafer horizontal in such a way that one or two of these elements 31 are actuated. The drive of the elements 31 may be effected by a command of the CPU 41 likewise to that of the vertically moving elements 24.

### Claims

1. A wafer surface contouring device (5) for use in an exposure apparatus for exposing a circuit pattern of a mask (7) on a wafer (6) in a step-and-repeat type transfer method, wherein in said wafer surface contouring device (5) a front surface of a wafer (6) is transformed into a predetermined shape by distorting forces applied upon the rear surface of the wafer (6) which is retained by vacuum suction on said rear surface, the wafer surface contouring device (5) comprising:
— a hollow case (16) closed on one lower open side by a base (12) on which said hollow case (16) is resting, said hollow case (16) on an upper open side being covered with a diaphragm type chuck (18), said hollow case (16), said base (12), and said diaphragm type chuck (18) forming an airtight space,
said diaphragm type chuck (18) having outside of said airtight space an upper surface formed with a suction groove for retaining said wafer (6) by vacuum suction; and
— a plurality of vertically moving elements (24) arranged at predetermined intervals in predetermined positions within said airtight space for applying said distorting forces upon said rear surface of said wafer (6) through said diaphragm type chuck (18);
characterized in that said wafer surface contouring device (5) further comprises drive means (41—50) for selectively actuating only the vertical moving elements (24) according to the area to be exposed on the wafer (6).

2. A wafer surface contouring device according to claim 1, wherein said each vertically moving element (29) comprises
a piezoelectric element (29),
a case member (25) attached to said piezoelectric element (29) and having an upper elastically deformable end part (30), and a chip means (27) for transmitting a displacement through said diaphragm type chuck (18) onto said wafer (6).

3. A wafer surface contouring device (5) according to claim 1, further comprising an annular stationary base (11) arranged outside said base (12), three second vertically moving elements (31) arranged on three places of said annular stationary base (11) and supporting said hollow case (16), and wherein coupling means (13) are provided for coupling said annular stationary base (11) and said base (12), so as to produce a relative displacement therebetween in a vertical direction by activating a piezoelectric element (37) of said second vertically moving elements (31).

4. A wafer surface contouring device (5) according to claim 3, wherein said coupling means (13) comprises leaf spring means.

5. A wafer surface contouring device (5) according to claim 1, further comprising a table means (2) for supporting said wafer surface contouring device (5) and means for moving the table means (2) so as to carry out a step-and-repeat movement to change the exposure areas of the wafer (6).

6. A wafer surface contouring device according to claim 1 or 2, wherein said drive means (41—50) comprises an amplifier means (49A—49B) connected to a drive source (48), and switching means (50) for supplying an output of said amplifier means (50) to said piezoelectric elements (24) of said vertically moving elements (24) for selectively actuating said vertically moving elements (24).

### Patentansprüche

1. Vorrichtung zum Profilieren der Oberfläche von Halbleiterplatten in einem Bestrahlungsgerät zur Bestrahlung eines durch eine Maske (7) gebildeten Schaltungsmusters auf einer Halbleiterplatte (6) in sich wiederholenden Muster-Übertragungsschritten, wobei eine Vorderfläche der Halbleiterplatte (6) in der Profilierungsvorrichtung (5) durch auf die Rückfläche der Halbleiterplatte einwirkende verzerrende Kräfte in eine vorgegebene Form umgewandelt wird und wobei die Halbleiterplatte (6) durch Unterdruckansaugung ihrer Rückfläche gehalten wird, mit
— einem hohlen Gehäuse (16), das auf seiner offenen unteren Seite durch eine Basis (12), auf der das hohle Gehäuse (16) ruht, geschlossen ist und auf seiner Oberseite von einem membranartigen Spannfutter bedeckt ist, so daß das hohle Gehäuse (16), die Basis (12) und das membranartige Spannfutter (18) einen luftdichten Raum bilden, wobei

— das membranartige Spannfutter (18) außerhalb des luftdichten Raums eine mit einer Ansaugnut zum Halten der Halbleiterplatte (6) durch Unterdruckansaugung versehene Oberfläche aufweist, und

— mehrere vertikal bewegliche Glieder (24), die in vorgegebenen Abständen und an vorgegebenen Stellen innerhalb des luftdichten Raums angeordnet sind, um die verzerrenden Kräfte der Rückseite der Halbleiterplatte (6) durch das membranartige Spannfutter (18) mitzuteilen;

dadurch gekennzeichnet, daß die Profilierungsvorrichtung (5) weiterhin Antriebsmittel (41—50) aufweist, die wahlweise nur diejenigen vertikal beweglichen Glieder (24) betätigen, die der auf der Halbleiterplatte zu bestrahlenden Fläche zugeordnet sind.

2. Vorrichtung zum Profilieren der Oberfläche von Halbleiterplatten nach Anspruch 1, dadurch gekennzeichnet,

daß jedes vertikal bewegliche Glied (24) ein piezoelektrisches Glied (29),

ein am piezoelektrischen Glied (29) angebrachtes Gehäuseglied (25), das einen oberen elastisch verformbaren Endteil (30) hat und ein Chip-Glied (27) umfaßt, das eine Versetzung durch das membranartige Spannfutter (18) auf die Halbleiterplatte (6) überträgt.

3. Vorrichtung zum Profilieren der Oberfläche von Halbleiterplatten nach Anspruch 1, weiterhin gekennzeichnet, durch

eine kreisförmige ruhende Basis (11), die außerhalb der Basis (12) angeordnet ist,

drei zweite vertikal bewegliche Glieder (31), die an drei Stellen der kreisförmigen ruhenden Basis (11) angeordnet sind und die das hohle Gehäuse (16) halten, wobei

Koppelglieder (13) zur Kopplung der kreisförmigen ruhenden Basis (11) mit der Basis (12) vorgesehen sind, um eine relative Versetzung zwischen der ruhenden Basis (11) und der Basis (12) in Vertikalrichtung durch Betätigen eines piezoelektrischen Glieds (37) der zweiten vertikal beweglichen Glieder (31) zu erzeugen.

4. Vorrichtung zum Profilieren der Oberfläche von Halbleiterplatten nach Anspruch 3, dadurch gekennzeichnet, daß die Koppelglieder (13) Blattfedern umfassen.

5. Vorrichtung zum Profilieren der Oberfläche von Halbleiterplatten nach Anspruch 1, weiterhin gekennzeichnet durch

einen Tisch (2), der die Profilierungsvorrichtung (5) trägt, und

eine Einrichtung, die den Tisch (2) bewegt, um eine sich schrittweise wiederholende Bewegung zur Veränderung der Bestrahlungsoberfläche der Halbleiterplatte (6) durchzuführen.

6. Vorrichtung zum Profilieren der Oberfläche von Halbleiterplatten nach Anspruch 1 oder 2, dadurch gekennzeichnet, daß die Antriebsmittel (41—50) einen Verstärker (49a—49b), der mit einer Speisequelle (48) verbunden ist und Schaltglieder (50) aufweisen, die das Ausgangssignal des Verstärkers den piezoelektrischen Gliedern (29) zur wahlweisen Betätigung der vertikal beweglichen Glieder (24) einspeisen.

**Revendications**

1. Dispositif (5) pour profiler la surface de pastilles semiconductrices, destiné à être utilisé dans un appareil d'exposition servant à former par exposition l'image d'un modèle d'un circuit situé sur un masque (7) sur une pastille (6) selon un procédé de transfert du type par copiage à répétition, selon lequel dans ledit dispositif (5) pour profiler la surface de pastilles semiconductrices, une surface avant d'une pastille (6) est transformée de manière à prendre une forme prédéterminée sous l'action de forces de déformation appliquées sur la surface arrière de la pastille (6), qui est retenue au moyen d'une aspiration par dépression appliquée à ladite surface arrière, le dispositif (5) pour profiler la surface de pastilles semiconductrices comprenant:

— un boîtier creux (12) fermé au niveau d'une face inférieure ouverte, par une base (12), sur laquelle ledit boîtier creux (16) repose, ledit boîtier creux (16) étant recouvert, au niveau de sa face ouverte supérieure, par un plateau de serrage (18) du type à diaphragme, ledit boîtier creux (16), ladite base (12) et ledit plateau de serrage (18) du type à diaphragme enserrant un espace étanche à l'air,

ledit plateau de serrage (18) du type à diaphragme comportant, à l'extérieur dudit espace étanche à l'air, une surface supérieure munie d'une rainure d'aspiration servant à retenir ladite pastille (6) par aspiration par dépression; et

— une pluralité d'éléments (24) déplaçables verticalement, disposés à des intervalles prédéterminés dans des positions prédéterminées à l'intérieur dudit espace étanche à l'air en vue d'appliquer lesdites forces de déformation à ladite surface arrière de ladite pastille (6) par l'intermédiaire dudit plateau de serrage (18) du type à diaphragme;

caractérisé en ce que ledit dispositif (5) pour profiler la surface de pastilles semiconductrices comporte en outre des moyens d'entraînement (41—50) permettant d'actionner de façon sélective uniquement les éléments (24) déplaçables verticalement, conformément à la surface, qui doit être soumise à l'exposition, sur la pastille (6).

2. Dispositif pour profiler la surface de pastilles semiconductrices selon la revendication 1, dans lequel chaque élément (29) déplaçable verticalement comporte

— un organe piézoélectrique (29),

— un élément de logement (25) fixé audit organe piézoélectrique (29) et comportant une partie d'extrémité supérieure (30) déformable élastiquement, et des moyens en forme de téton (27) pour transmettre un déplacement à ladite pastille (6), par l'intermédiaire dudit plateau de serrage (18) du type à diaphragme.

3. Dispositif (5) pour profiler la surface de pastilles semiconductrices selon la revendication 1, comprenant en outre une base annulaire fixe (11) disposée à l'extérieur de ladite base (12), trois seconds éléments (31) déplaçables verticalement, situés en trois emplacements de ladite base annulaire fixe (11) et supportant ledit boîtier creux (16), et dans lequel des moyens d'accouplement (13) sont prévus pour réaliser l'accouplement de ladite base annulaire fixe (11) et de ladite base (12) de manière à produire un déplacement relatif, dans une direction verticale, entre ces bases par activation d'un organe piézoélectrique (37) desdits seconds éléments (31) déplaçables verticalement.

4. Dispositif (5) pour profiler la surface de pastilles semiconductrices selon la revendication 3, dans lequel lesdits moyens d'accouplement (13) comprennent des moyens en forme de ressorts à lames.

5. Dispositif (5) pour profiler la surface de pastilles semiconductrices selon la revendication 1, comportant en outre des moyens en forme de plateau (2) servant à supporter ledit dispositif (5) pour profiler la surface de pastilles semiconductrices, et des moyens pour déplacer les moyens en forme de plateau (2) de manière à exécuter un déplacement de copiage à répétition afin de modifier les surfaces d'exposition de la pastille (6).

6. Dispositif pour profiler la surface de pastilles semiconductrices selon la revendication 1 ou 2, dans lequel lesdits moyens d'entraînement (41—50) comprennent des moyens amplificateurs (49A—49B) raccordés à une source d'entraînement (48), et des moyens de commutation (50) servant à envoyer un signal de sortie desdits moyens amplificateurs (5) auxdits organes piézoélectriques (24) desdits éléments (24) déplaçables verticalement, de manière à actionner de façon sélective lesdits éléments (24) déplaçables verticalement.

*FIG. 1*

*FIG. 2*

## FIG. 3

## FIG. 4

*FIG. 5*

# FIG. 6